## Europäisches Patentamt
## European Patent Office
## Office européen des brevets

(11) Publication number: **0 077 200 B1**

(12) **EUROPEAN PATENT SPECIFICATION**

(45) Date of publication of patent specification: **09.08.89**

(51) Int. Cl.⁴: **H 01 L 21/316, H 01 L 29/62**

(21) Application number: **82305379.8**

(22) Date of filing: **08.10.82**

(54) **Producing insulating layers in semiconductor devices.**

(30) Priority: **09.10.81 JP 161281/81**

(43) Date of publication of application:
**20.04.83 Bulletin 83/16**

(45) Publication of the grant of the patent:
**09.08.89 Bulletin 89/32**

(84) Designated Contracting States:
**DE FR GB**

(56) References cited:
**DE-A-1 923 279**

**APPLIED PHYSICS LETTERS, vol. 38, no. 1, 1st January 1981, pages 33-35, New York, US; S.GOURRIER et al.: "Enhanced plasma oxidation at low temperature using a thin solid electrolyte film"**

**IEEE TRANSACTIONS ON ELECTRON DEVICES, vol. 23, no. 5, May 1976, pages 527-529, New York, US; A.G.REVESZ et al.: "Electronic properties of the silicon-thermally grown tantalum oxide interface"**

The file contains technical information submitted after the application was filed and not included in this specification

(73) Proprietor: **FUJITSU LIMITED**
**1015, Kamikodanaka Nakahara-ku Kawasaki-shi Kanagawa 211 (JP)**

(72) Inventor: **Kato, Takashi**
**Fujitsu-Daini-Yurigaoka-ryo 2-7-5, Chiyogaoka Asao-ku Kawasaki-shi Kanagawa 215 (JP)**
Inventor: **Toyokura, Nobuo**
**1569-1, Shinsaku Takatsu-ku Kawasaki-shi Kanagawa 213 (JP)**

(74) Representative: **Fane, Christopher Robin King et al**
**HASELTINE LAKE & CO. Hazlitt House 28 Southampton Buildings Chancery Lane London, WC2A 1AT (GB)**

(56) References cited:
**Journal Appl. Phys., vol. 36, no. 12, pp. 3770-3778**

**S.M. Sze: Semiconal Devices, J. Wiley & Sons, pp. 347-348**

**Journ. Electrochem.Soc., Jan. 76, vol. 123, no. 1, pp. 42-47**

EP 0 077 200 B1

## Description

The present invention relates to the production of insulating layers in semiconductor devices.

Dielectric layers are essential features of some semiconductor devices, for example, gate insulating layers in field effect transistors and dielectric layers of capacitors. Such devices may be included in components comprising transistor-diode logic, transistor-transistor logic, ready only memory, or dynamic random access memory.

Generally, the capacitance of capacitors is proportional to the relative dielectric constant of the dielectric material inserted between electrodes and inversely proportional to the distance between the electrodes. The transconductance gm of field effect transistors is also proportional to the relative dielectric constant of the gate-insulating dielectric layer and inversely proportional to the thickness of the layer. Thus, it is desirable to produce dielectric layers of a material which has a high relative dielectric constant and also a high dielectric breakdown voltage.

Silicon dioxide ($SiO_2$) layers have been mainly used as dielectric layers, the functions of which are set forth above, based on the fact that silicon dioxide has a relative dielectric constant of 3.8 and a dielectric breakdown voltage of 10 MV/cm. However, it has been found difficult to form a silicon dioxide layer the thickness of which is less than 10 nm without pinholes which will inevitably lead to an increased leakage of current, and, consequently, a lower breakdown voltage.

Recently, in order to reduce the size of the elements and thus improve the integration of the elements, other dielectric materials having a relative dielectric constant higher than that of silicon dioxide have been used either tentatively or practically. Such dielectric materials are oxides of tantalum (Ta), titanium (Ti), niobium (Nb), hafnium (Hf), zirconium (Zr), yttrium (Y), and vanadium (V). For example, tantalum oxide exhibits a relative dielectric constant of from 20 to 28.

However, each of these dielectric oxides has disadvantages in that the breakdown voltage is low and the leakage of current is large. Of course, these disadvantages may be reduced by thickening the dielectric layer, but this leads to unfavorable lowering of the capacitance.

In attempting to increase the breakdown voltage and decrease the leakage of current, a $Ta_2O_5/SiO_2$ double layer may be used in which a silicon dioxide layer is first formed on a substrate and then a tantalum oxide ($Ta_2O_5$) layer is formed thereon so as to form the $Ta_2O_5/SiO_2$ double layer.

However, such a $Ta_2O_5/SiO_2$ double structure exhibits a disadvantage in that the capacitance is low due to the thickness of the oxidized silicon, which thickness cannot be reduced owing to the occurrence of pin holes, as mentioned above. Furthermore, the electrical properties of the previously formed silicon dioxide layer deteriorate during the formation of tantalum oxide thereon, thereby lowering the breakdown voltage. In addition, such a double structure exhibits an unfavorable hysteresis in respect to the capacitance-voltage characteristic of a diode due to the abrupt heterojunction thereof.

According to the present invention there is provided a method of manufacturing a semiconductor device, wherein

a first layer of an oxide of an element selected from the group made up of tantalum, titanium, niobium, hafnium, yttrium, zirconium, and vanadium is formed on a semi-conductor substrate, and an electrically conductive layer is formed on said oxide layer, characterized in that the said semiconductor substrate having said layer of oxide thereon is heated in an oxidizing atmosphere comprising wet oxygen at a temperature in the range of 700 to 1200°C so as to oxidize semiconductor material of the said substrate and thereby form an insulating layer made of an oxide of said semiconductor material, sandwiched between said layer of oxide and remaining semiconductor material of the said substrate, said insulating layer being used as a gate insulating layer or a capacitor insulating layer.

The first oxide layer may be formed by depositing a layer of the respective element on the semiconductor substrate and oxidizing that layer.

In one embodiment of the invention the oxide layer comprises a tantalum oxide layer, and the semiconductor layer may advantageously be made of silicon.

A preferred embodiment of the present invention provides a process for producing a gate insulating or capacitor dielectric layer on a silicon semiconductor layer, characterized by the steps of:

depositing a tantalum layer on the surface of said silicon semiconductor layer;

oxidizing said tantalum layer, thereby converting tantalum into tantalum oxide;

heating said silicon semiconductor layer having said tantalum oxide layer thereon in an oxidizing atmosphere comprising wet oxygen at a temperature in the range of 700 to 1200°C, thereby thermally oxidizing the silicon constituting said semicodnuctor layer so as to form an insulating layer which comprises silicon oxide at the interface between said semiconductor layer and said tantalum oxide layer; and

forming an electrically conductive layer on said tantalum oxide layer.

It is desirable that said silicon semiconductor layer is of a one-conductivity type.

An embodiment of the present invention can provide a process for producing a gate insulating or capacitor dielectric layer having a desirably high relative dielectric constant, a relatively high dielectric breakdown voltage, and desirably small current leakage. Such a dielectric layer can be made to exhibit very low hysteresis in respect to the capacitance-voltage characteristic of a diode.

It has been noted that A. G. Revesz et al of Comsat Laboratories teach in "Film-Substrate Interaction in Si/Ta and Si/Ta$_2$O$_5$ Structures" in the Journal of the Electrochemical Society, Vol. 123, No. 10, October 1976, that if a tantalum film is deposited on a silicon substrate and oxidized, the resultant tantalum oxide film contains a significant amount of silicon, and the majority of the silicon atoms incorporated into the tantalum oxide film are concentrated near the interface while a small amount of the silicon atoms are concentrated at the outer surface of the tantalum oxide film. During oxidation, the thus-diffused silicon atoms are also oxidised by oxygen, which diffuses through the tantalum oxide. However, Revesz et al do not suggest the forming of an effective silicon oxide layer under the tantalum oxide layer so as to realize a dielectric layer to form a necessary feature of a semiconductor device.

In addition, B. E. Deal et al teach in "General Relationship for the Thermal Oxidation of Silicon" in the Journal of Applied Physics, Vol. 36, No. 12, December 1965, that silicon is oxidized more quickly in wet oxygen than in dry oxygen. However, they do not suggest that oxygen can diffuse through a tantalum oxide layer.

DE—A—1 923 279 discloses that oxygen can diffuse through a layer of $TiO_2$, $Nb_2O_5$, $TaO_2$ or $ZrO_2$ and oxidise an underlying silicon substrate.

Reference will now be made, by way of example, to the accompanying drawings, in which

Figures 1a through 1c are sectional diagrams of part of a semiconductor device at different stages of a method embodying the present invention.

Figure 2 is a graph showing the relationship between the amount of elements and the depth of a dielectric layer of Fig. 1c.

Figure 3 is a graph showing the relationship between the thickness of the oxidized silicon and the oxidation temperature.

Figure 4 is a graph showing the relationship between the thickness of the oxidized silicon and the oxidation time.

Figure 5 is a graph showing the relationship between the leakage of current and the voltage across the dielectric layer of Fig. 1c.

Figures 6 through 12 are diagrams showing the steps for producing a dynamic random access memory device.

Figures 13 through 16 are diagrams showing steps for producing a MOS field effect transistor.

Figures 17 through 20 are diagrams showing steps for producing a 1(one)-transistor type nonvolatile memory devices.

Figures 21 and 22 are diagrams showing the function of a 1-transistor type nonvolatile memory device.

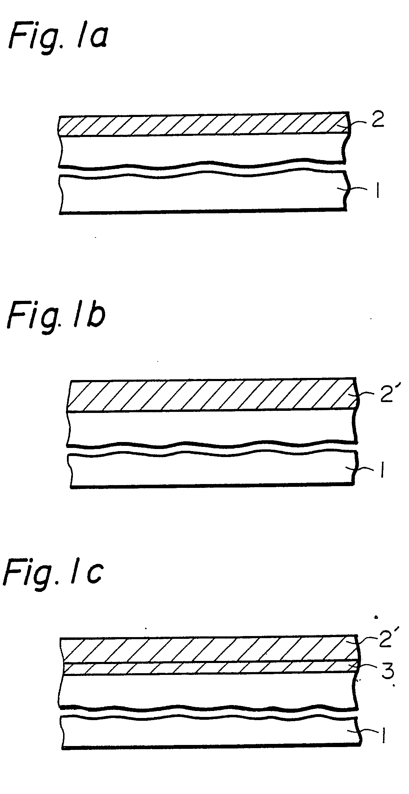

A high dielectric layer (2'), e.g., tantalum oxide ($Ta_2O_5$), may be formed on a semiconductor substrate (1) either by an indirect process, e.g., first depositing tantalum (2) by vacuum vapor deposition or sputtering (Fig. 1a) and then oxidizing tantalum into tantalum oxide (2'), or by a direct process, e.g., chemical vapor deposition or oxide sputtering (Fig. 1b). The thus-obtained oxide may be further subjected to a thermal treatment, whereby the oxide may be crystallized and improved in respect to thermal stability.

The low breakdown voltage of the tantalum oxide (2') is compensated for according to the invention by heating the substrate (1) in an oxidizing atmosphere comprising wet oxygen so as to form a layer of oxide of the semiconductor material (3), e.g., silicon oxide, mainly at the interface between the semiconductor substrate (1) and the tantalum oxide (2') (Fig. 1c).

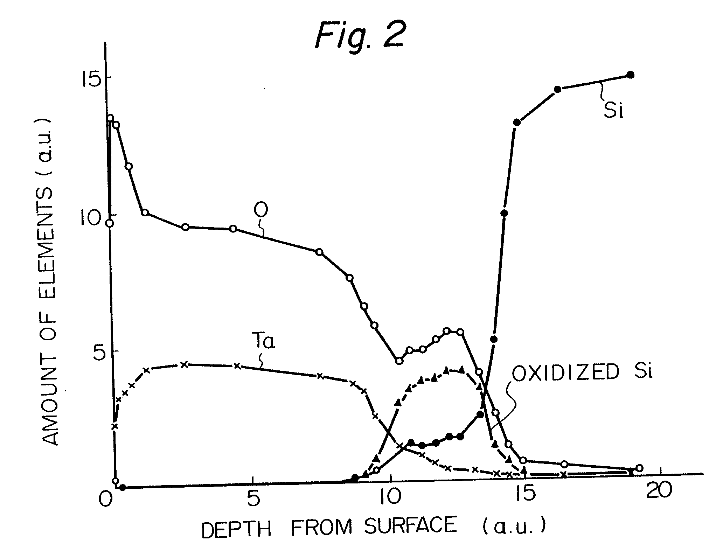

The thus-formed composite oxide layer is better illustrated in Fig. 2. The composition was determined by the Auger sputtering method. At the end of the tantalum region, the silicon shifted in a combined state with the oxygen (Fig. 2).

In the following experiments, the total thickness of the oxide layer was determined by the Talystep method before and after oxidation and then the difference in thickness was assumed to be the thickness of oxidized silicon.

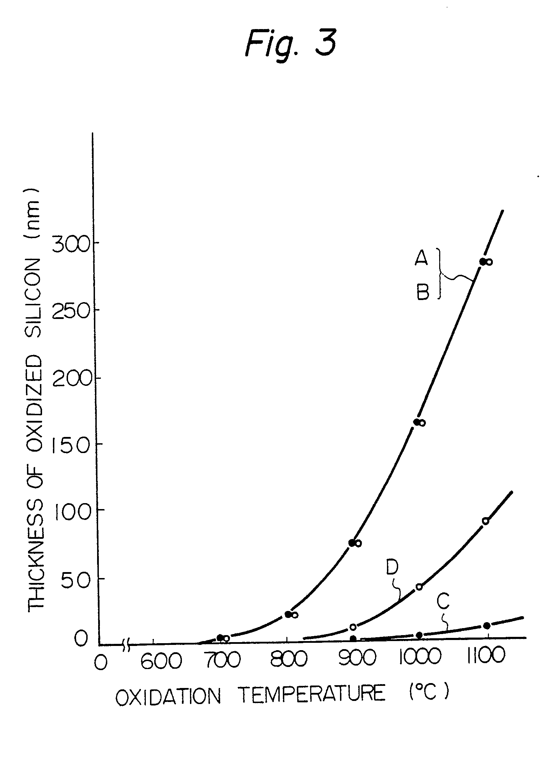

A silicon substrate coated with tantalum oxide 45 nm thick (A) and a bare silicon substrate B were oxidized in wet oxygen (Fig. 3). A silicon substrate coated with tantalum oxide 24 nm thick (C) and a bare silicon substrate (D) were oxidized in dry oxygen (Fig. 3). These thermal treatments were continued for 30 minutes at various temperatures.

The substrates (A, B) were oxidized quickly in wet oxygen without regarding the coating of tantalum oxide and were effective at a temperature higher than 700°C. Contrary to this, the substrates (C, D) were oxidized slowly in dry oxygen, particularly in the case coated with tantalum oxide, and were oxidized only at a temperature higher than 900°C. An oxidation temperature higher than 1200°C exhibited no advantages in respect to the consumption of energy in relation to either wet or dry oxidation.

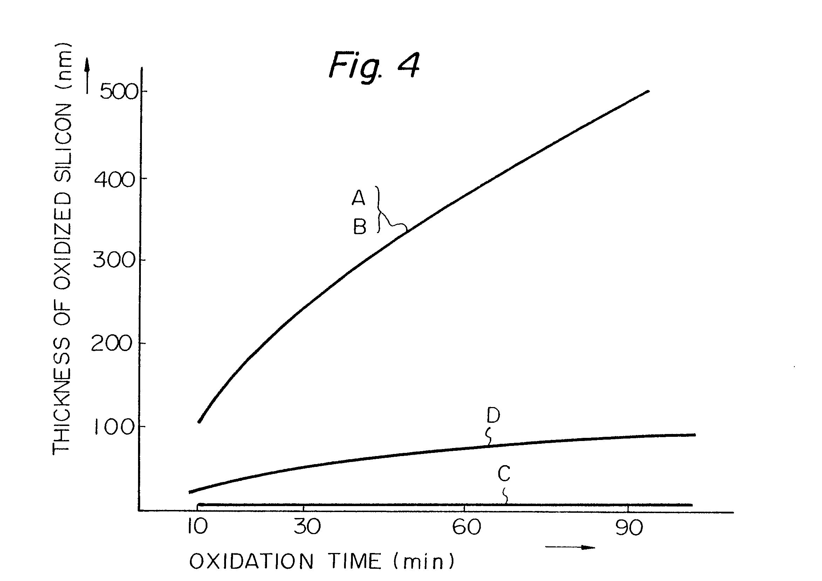

The thickness of the oxidized silicon gradually increased as heating of the silicon semiconductor substrates A, B, C and D used in the experiment of Fig. 3 was continued (Fig. 4). These substrates A, B, C, and D were heated at 1000°C. Wet oxidation (A, B) was superior to dry oxidation (C, D) in respect to their growth.

As can be seen from the graphs of Figs. 3 and 4, oxygen in a wet oxygen atmosphere diffuses freely through the tantalum oxide layer. Contrary to this, oxygen in a dry oxygen atmosphere scarcely diffuses therethrough. Furthermore, it was confirmed that oxygen in a wet oxygen atmosphere diffuses several μm laterally through a tantalum layer 45 nm thick.

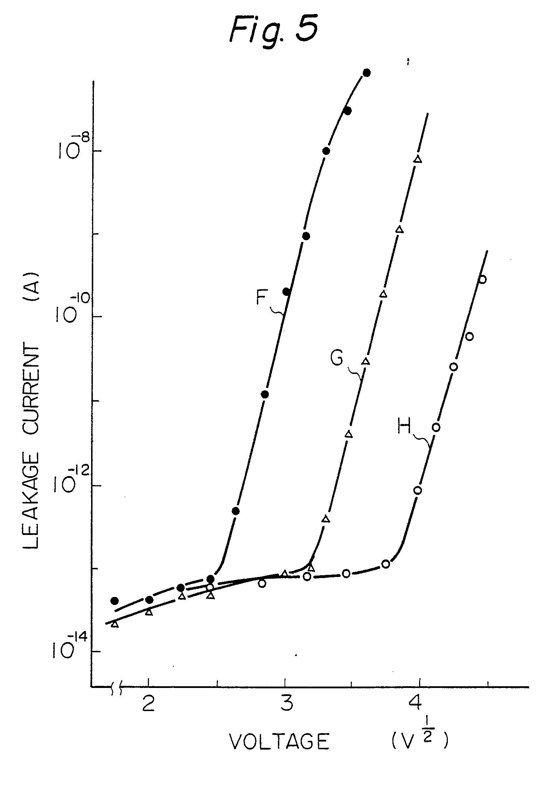

A silicon substrate coated with tantalum oxide 45 nm thick was heated in wet oxygen at 800°C. Oxidation was continued for 10 minutes (F), 20 minutes (G) and 30 minutes (H) (Fig. 5). Thus, the silicon at the interface was oxidized so as to produce a dielectric layer according to the present invention. The dielectric layers F, G, and H, which correspond to the curves F, G, and H, had a breakdown voltage of approximately 6 V, 10 V, and 15 V, respectively, and an effective dielectric constant of 13, 11, and 9, respectively.

The $SiO_2$ layer formed at the interfaces of $Ta_2O_5$—Si substrate by oxidation after coating the

substrate with $Ta_2O_5$ included almost no pin holes and consequently exhibited a breakdown voltage much higher than that of a $SiO_2$ layer formed by thermal oxidation of a bare silicon substrate in a conventional manner. Thus, double oxide layer produced in a method embodying the present invention, can exhibit a high dielectric constant and a high breakdown voltage.

Example 1

A layer of tantalum 15 nm thick (2) was deposited on a silicon substrate (1) by RF sputtering in argon at 52 Pa ($4 \times 10^{-2}$ Torr) (Fig. 1a).

The substrate (1) was heated in dry oxygen at 525°C for 40 minutes. As a result, a tantalum oxide (2') layer 33 nm thick was formed (Fig. 1b). The substrate (1) having a tantalum oxide layer (2') thereon was heated in wet oxygen at 800°C for 13 minutes. Oxide layers (3) comprising silicon oxide were produced mainly under the tantalum oxide layer, i.e., the thickness of the silicon oxide was 0.3 nm on the surface and 5 nm at the interface between the tantalum oxide layer (2') and the silicon substrate (1), respectively (Fig. 1c). In addition, a very thin silicon oxide layer (not shown) was formed on the surface of the tantalum oxide layer (2') during oxidation in a wet oxygen atmosphere. The substrate was annealed in nitrogen containing 5% by volume of hydrogen at 1050°C for 30 minutes and then electrodes were produced (not shown). The thus-obtained dielectric layer composite having silicon oxide in addition to tantalum oxide exhibited a relative dielectric constant of 15, a dielectric breakdown voltage of 4 MV/cm, and a leakage current on the order of $10^{-10}$ A at 5 V. The relative dielectric constant was more than three times greater than that of silicon oxide, and the breakdown voltage was several times greater than that of tantalum oxide. In addition, this composite exhibited no hysteresis in respect to the capacitance-voltage characteristic of a diode.

Furthermore, it is preferable that the amount of silicon contained in an electrode of silicide of a high melting point metal, e.g., molybdenum silicide, which is formed on the tantalum oxide layer not exceed the stoichiometry ratio.

Our experiment revealed that in the case where the molybdenum silicide layer of the upper electrode is $MoSi_3$, i.e., rich in silicon, an increase in the leakage of current is evident and that, contrary to this, a layer of MoSi or $MoSi_2$ does not exhibit an increased leakage of current even after thermal treatment at 1000°C.

We consider the reason for this to be as follows. Silicon atoms pile up from the molybdenum silicide layer at the interface between the molybdenum silicide layer and the tantalum oxide layer (2') so as to form an apparent Si—$Ta_2O_5$ interface in the case where the molybdenum silicide layer is rich in silicon, and, thus, Si and $Ta_2O_5$ diffuse and react with each other.

Contrary to this, $MoSi_2$ satisfies the stoichiometry ratio, i.e., it does not discharge silicon atoms. Molybdenum atoms which pile up from a MoSi layer, however, do not react with $Ta_2O_5$, which is thermodynamically stable in the Mo—$Ta_2O_5$ system.

Thus, the upper electrode 4 of the molybdenum silicide layer formed on the tantalum oxide layer 3 must not contain silicon in an amount in excess of the stoichiometry ratio.

This holds true not only for the MoSi—$Ta_2O_5$ system but also for other silicide-oxide systems which comprises silicide, e.g., of tungsten, tantalum, or platinum and oxide of a metal in the group 3A, 4A, or 5A of the periodic table of elements.

Example 2

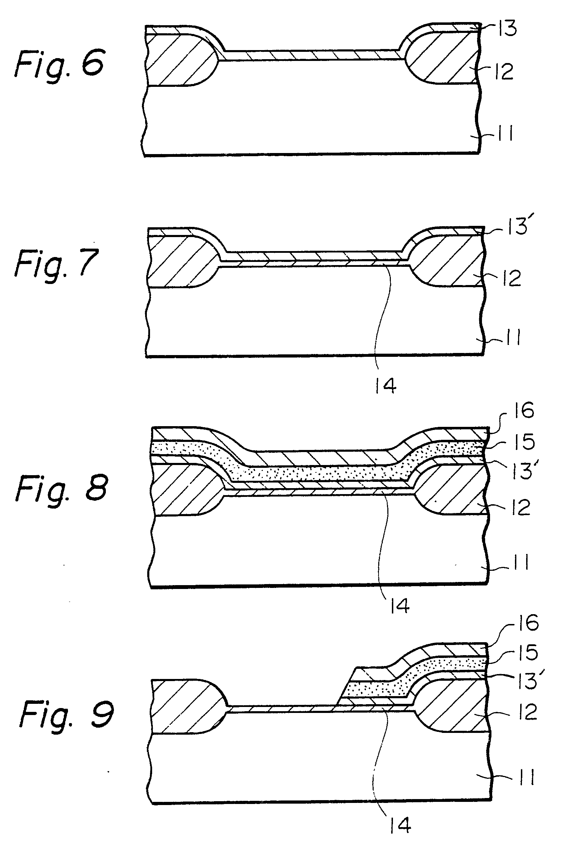

Figures 6 through 12 are diagrams showing the steps for producing a dynamic random access memory device by a method embodying the present invention.

Field oxide layers (12) 1 μm thick were produced on a p type silicon semiconductor substrate (11) in a usual manner. A tantalum layer (13) 20 nm thick was produced on the substrate by RF sputtering in argon at $4 \times 10^{-2}$ Torr with an accelerating voltage of 2.3 KV (Fig. 6).

The tantalum layer (13) was converted to a tantalum oxide layer (13') 44 nm thick by heating it at 500°C and then heating the substrate (11) at 800°C in wet oxygen, and thereby a silicon oxide layer (14) 6 nm thick was produced at the interface between the silicon substrate (11) and the tantalum oxide layer (13') (Fig. 7).

A molybdenum (Mo) or molybdenum silicide electrode (15) for capacitor electrode was sputtered on the tantalum oxide layer (13') and then an insulating layer (16) of silicon oxide was deposited by chemical vapor deposition (Fig. 8).

The insulating layer (16), the capacitor electrode (15), and the tantalum oxide layer (13') were partly removed by dry etching with a $CHF_3$ etchant, thus partially exposing the silicon oxide layer (14) at the interface (Fig. 9).

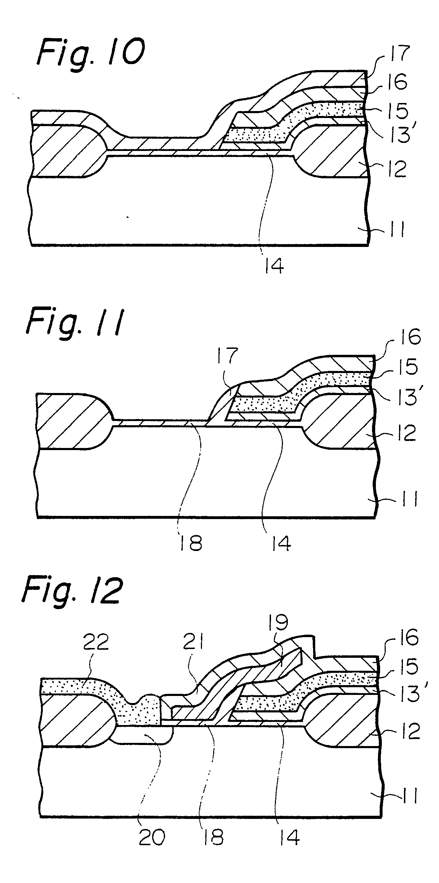

A silicon oxide layer (17) was further deposited by chemical vapor deposition (Fig. 10). The silicon oxide layer (17) was removed, except for the portion coating the side surface (side wall) of the capacitor electrode (15), by dry etching. Then a transfer gate insulating layer (18) 40 nm thick was formed on the silicon substrate (11) by thermal oxidation (Fig. 11).

A transfer gate electrode (19) was formed by depositing and patterning polycrystalline silicon. Then, a $n^+$ type bit line contact region (20) was formed by arsenic (As) ion implantation, whereby arsenic was implanted into the transfer gate electrode (19). An electrode contact window was opened by forming and patterning the silicon oxide layer (21). A bit line (22) was formed by depositing and patterning an aluminum layer (Fig. 12).

The thus-obtained dynamic random access memory device exhibited a significantly small leakage current and a higher integration.

Example 3

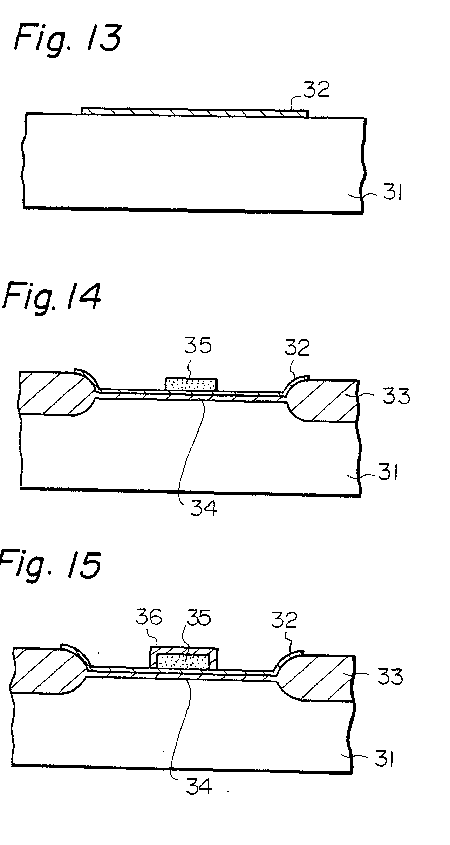

Figures 13 through 16 are diagrams showing the steps for producing a MOS field effect transistor by a method embodying the present invention.

A tantalum oxide layer (32) 50 nm thick was produced on a p type silicon semiconductor substrate (31) in a manner similar to that of Example 2 (Fig. 13) and was removed, except for the portion coating the positive regions, by a conventional process. Field oxide layers (33) were produced on the field region in a usual manner. A silicon oxide layer (34) was formed by thermal oxidation in wet oxygen at 800°C for 50 minutes at the interface between the tantalum oxide layer (32) and the silicon substrate (31). A polycrystalline silicon gate electrode (35) was formed by chemical vapor deposition and dry etching with a $CCl_4$ etchant (Fig. 14).

An oxide layer (36) was formed on the gate electrode (35) by heating the substrate in dry oxygen (Fig. 15).

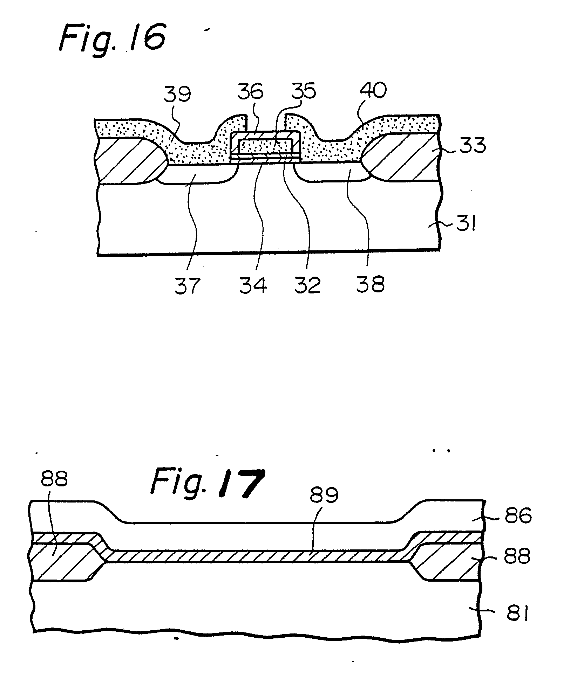

Contact windows were opened by exposing the positive regions in the insulating silicon oxide layer (34) by self-alignment patterning of the tantalum oxide layer (32). Then n type source and drain regions (37, 38) were formed by soft etching and ion implantation. Source and drain electrodes (39, 40) were formed by self-alignment patterning of the insulating layer (36) and by depositing and patterning aluminum by means of conventional photolithography technique (Fig. 16).

As contact windows are opened by self-alignment, a short channel gate transistor can be easily realized.

Example 4

Figures 17 through 22 are diagrams showing the steps for producing a 1(one)-transistor type nonvolatile memory device.

Field oxide layers (88) and a tantalum oxide layer (89) 44 nm thick were produced on a p type silicon substrate (81) in a manner similar to that of Example 2. Then a polycrystalline silicon layer (86) 500 nm thick was formed on the tantalum oxide layer (89) by chemical vapor deposition (Fig. 17).

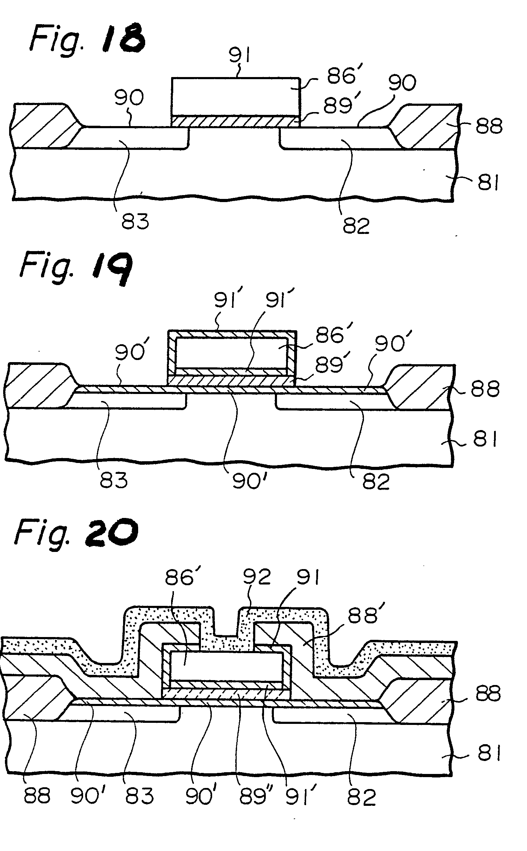

These layers (86, 89) were selectively removed so as to form a polycrystalline silicon gate electrode (86') and the second insulating layer of tantalum oxide (89'). N type source and drain regions (82, 83) were produced by masking with these layer (86', 89') and implanting arsenic as a donor type impurity into the substrate (81) (Fig. 18).

The substrate was subjected to thermal oxidation in wet oxygen at 800°C for 10 minutes. Thus, the exposed silicon surfaces (90, 91) of the substrate and the gate electrode were oxidized. In addition, oxygen diffused through the tantalum oxide layer (89') so as to form the first and the third insulating layers of silicon oxide (91', 90') under the gate electrode (86') (Fig. 19).

The substrate was annealed in a mixture of nitrogen and 5% by volume of hydrogen at 1000°C for 20 minutes so as to reduce the tantalum oxide layer (89'). Consequently, a number of traps were produced due to the vacancy of oxygen in the reduced oxide layer (89''), which traps could accumulate electric charge (Fig. 20).

During the annealing, silicon in the gate electrode (86') and the substrate (81) was oxidized very slightly, probably due to the discharge of oxygen generated by the reduction of $Ta_2O_5$ with hydrogen. Then, a word line (92) of aluminum was produced on the gate electrode (86'), after a contact hole was opened in the silicon oxide layer (88'), in a usual manner (Fig. 20).

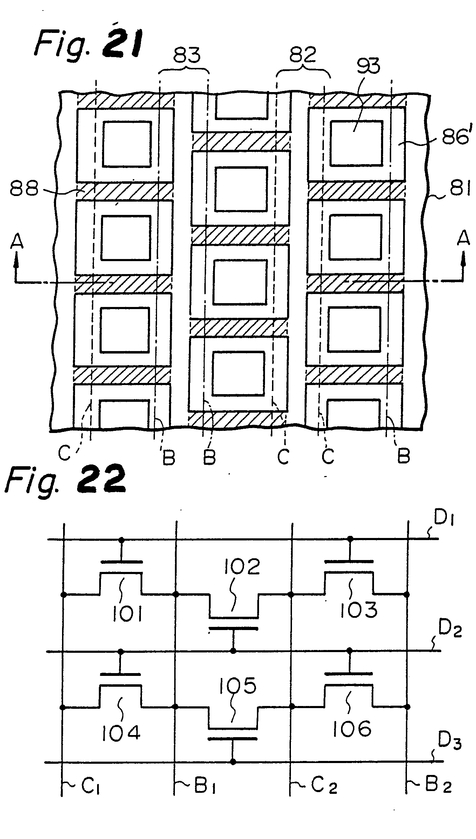

Figure 21 is a plan of a 1-transistor type nonvolatile semiconductor random access memory device and indicates the following elements: field insulating oxide layers (88), gate electrodes (86'), contact holes (93) opened on the gate electrodes (86'), an n type region (83) constituting bit lines defined by the adjacent dot-dash lines B, and an n type region (82) constituting earth lines defined by the adjacent broken lines C. However, insulating silicon oxide layers (88' in Fig. 20 and aluminum word lines (92 in Fig. 20) are not shown (Fig. 21).

The operation principle of the 1-transistor type nonvolatile semiconductor memory will be illustrated with reference to Fig. 22, which shows an equivalent circuit of the random access memory shown in Fig. 21.

Figure 22 illustrates bit lines $B_1$, $B_2$ and earth lines $C_1$, $C_2$ connected to drains and sources of each transistor, respectively, and word lines $D_1$, $D_2$, $D_3$ connected to gates of each transistor. These constitute the memories 101 through 106.

In order to write only in cell 101, a potential 10 V is applied to word line $D_1$, and bit line $B_1$ is grounded. Thus, a writing voltage of 10 V is applied to the gate of cell 101. Electrons are injected and accumulated from n type region constituting the bit line into the second insulating layer of tantalum oxide in the gate. At the same time, bit lines $B_2$ of cell 103 is maintained at an open potential so as to inhibit writing in cell 103 connected to the same word line as cell 101, and earth lines $C_1$, $C_2$ are also maintained at an open potential so as to inhibit electron injection from the earth lines into cells 101 and 103.

In order to read out from cell 101, potentials +3 V and +5 V are applied to word line $D_1$ and bit line $B_1$, respectively, and, then, it is determined whether the cell is ON or OFF, i.e., the absence of and the accumulation of electrons in the gate result in a current and no current between the source and drain, respectively.

Erasing the memory is carried out inversely to the writing procedure. Word line $D_1$ is grounded and a potential 10 V is applied to bit line $B_1$. Consequently, electrons accumulated in the gate are erased by the tunnel effect up to the n type region constituting the bit line. Bit line $B_1$ is connected to other cells 102, 104, 105. In order to avoid erasing of information written in these cells, a potential +5 V is applied to word lines $D_2$, $D_3$. Thus, the effective electron discharge voltage is 5 V, which does not cause the tunnel effect. In addition, earth lines $C_1$, $C_2$ on both sides of bit line $B_1$ are maintained at an open potential, thereby inhibiting current flow into the adjacent cells.

## Claims

1. A method of manufacturing a semiconductor device, wherein a first layer (2') of an oxide of an element selected from the group made of tantalum, titanium, niobium, hafnium, yttrium, zirconium, and vanadium is formed on a semiconductor substrate (1) and an electrically conductive layer is formed on said first layer (2') of an oxide, characterized in that the said semiconductor substrate having said first layer of an oxide thereon is heated in an oxidising atmosphere comprising wet oxygen at a temperature in the range of 700 to 1200°C so as to oxidize semiconductor material of the said substrate and thereby form an insulating layer (3) made of an oxide of said semiconductor material, sandwiched between said first layer of an oxide and remaining semiconductor material of the said substrate, said insulating layer (3) being used as a gate insulating layer or a capacitor insulating layer.

2. A method as claimed in claim 1, wherein the said semiconductor material comprises silicon.

3. A method as claimed in claim 1 or 2 wherein the said element is tantalum.

4. A method as claimed in any preceding claim, including the steps of depositing a layer (2) of the said element on the said semiconductor substrate, and oxidizing that layer so as to produce the said first layer of an oxide.

5. A method as claimed in any preceding claim, wherein the said semiconductor substrate is of p-type conductivity.

6. A method as claimed in any one of claims 1 to 4, wherein the said semiconductor substrate is of n-type conductivity.

## Patentansprüche

1. Verfahren zur Herstellung einer Halbleitervorrichtung, bei der eine erste Schicht (2') aus einem Oxid von einem Element ausgewählt aus der Gruppe bestehend aus Tantal, Titan, Niob, Hafnium, Yttrium, Zirkon und Vanadium auf einem Halbleitersubstrat (1) geformt wird und eine elektrisch leitende Schicht auf der genannten ersten Schicht (2') aus einem Oxid gebildet wird, dadurch gekennzeichnet, daß das genannten Halbleitersubstrat, auf welchem die genannte erste Schicht aus einem ersten Oxid ist, in einer oxidierenden Atmosphäre erhitzt wird, die feuchten Sauerstoff enthält, bei einer Temperatur im Bereich von 700 bis 1200°C, um so das Halbleitermaterial des genannten Substrats zu oxidieren und dadurch eine isolierende Schicht (3) zu bilden, die aus einem Oxid des genannten Halbleitermaterials besteht und sandwichartig zwischen der genannten ersten Schicht aus erstem Oxid und dem verbleibenden Halbleitermateriral von dem Substrat angeordnet ist, welche genannte isolierende Schicht (3) als eine Gate-Isolierschicht oder als eine Kondensator-Isolierschicht verwendet wird.

2. Verfahren nach Anspruch 1, bei dem das genannte Halbleitermaterial Silicium umfaßt.

3. Verfahren nach Anspruch 1, bei dem das genannte Element Tantal ist.

4. Verfahren nach einem der vorhergehenden Ansprüche, einschließlich der Schritte des Abscheidens einer Schicht (2) aus dem genannten Element auf dem genannten Halbleitersubstrat und des Oxidierens jener Schicht, um so die genannte erste Schicht aus einem Oxid zu erzeugen.

5. Verfahren nach einem der vorhergehenden Ansprüche, bei dem das genannte Halbleitersubstrat vom p-Leitfähigkeitstyp ist.

6. Verfahren nach einem der Ansprüche 1 bis 4, bei dem das genannte Halbleitersubstrat vom n-Leitfähigkeitstyp ist.

## Revendications

1. Procédé de fabrication d'un dispositif semiconducteur, où on forme sur un substrat semiconducteur (1) une première couche (2') d'un oxyde d'un élément choisi dans le groupe formé du tantale, du titane, du niobium, du hafnium, de l'yttrium, du zirconim, et du vanadium, et on forme une couche électriquement conductrice sur ladite première couche (2') d'un oxyde, caractérisé en ce qu'on chauffe ledit substrat semiconducteur portant ladite première couche d'un oxyde dans une atmosphère oxydante comprenant de l'oxygène humide à une température comprise entre 700 et 1200°C de manière à oxyder le matériau semiconducteur dudit substrat et à ainsi former une couche isolante (3) faite d'un oxyde dudit matériau semiconducteur, prise en sandwich entre ladite première couche d'un oxyde et le matériau semiconducteur restant dudit substrat, ladite couche isolante (3) étant utilisée comme couche isolante de grille ou comme couche isolante de condensateur.

2. Procédé selon la revendication 1 où ledit matériau semiconducteur est constitué de silicium.

3. Procédé selon la revendication 1 ou 2, où ledit élément est le tantale.

4. Procédé selon l'une quelconque des revendications précédentes, comportant les opérations qui consistent à faire déposer une couche (2) dudit élément sur ledit substrat semiconducteur et à oxyder cette couche de manière à produire ladite première couche d'un oxyde.

5. Procédé selon l'une quelconque des revendications précédentes, où ledit substrat semiconducteur a une conductivité de type p.

6. Procédé selon l'une quelconque des revendication 1 à 4, où ledit substrat semiconducteur a une conductivité de type n.

*Fig. Ia*

2

1

*Fig. Ib*

2´

1

*Fig. Ic*

2´

3

1

Fig. 2

# Fig. 3

Fig. 4

# Fig. 5

Fig. 6

Fig. 7

Fig. 8

Fig. 9

*Fig. 10*

*Fig. 11*

*Fig. 12*

*Fig. 13*

32

31

*Fig. 14*

35    32

33

31

34

*Fig. 15*

36   35    32

33

31

34

## Fig. 16

## Fig. 17

Fig. 18

Fig. 19

Fig. 20

*Fig.* **21**

*Fig.* **22**